# EUROPEAN PATENT APPLICATION

(11) **EP 4 525 585 A2**
(43) Date of publication of application: **19.03.2025**
(21) Application number: 24195018.7
(22) Date of filing: 16.08.2024
(51) Int. Cl.: H10D 84/01, H10D 30/01, H10D 62/10

(54) **SEMICONDUCTOR DEVICE**

(30) Priority: 25.08.2023 KR 20230111776
(71) Applicant: Samsung Electronics Co., Ltd, Suwon-si, Gyeonggi-do 16677 (KR)
(72) Inventor: YANG, Youngjin, 16677 Suwon-si (KR); PARK, Kyunam, 16677 Suwon-si (KR); JEON, Jaeho, 16677 Suwon-si (KR); PARK, Kyoungmi, 16677 Suwon-si (KR)
(74) Representative: Marks & Clerk LLP

(57) **Abstract**

A semiconductor device includes an insulating base layer, a plurality of semiconductor patterns stacked on the insulating base layer and spaced apart from each other, a gate structure surrounding the plurality of semiconductor patterns, first and second source/drain patterns disposed on the insulating base layer and connected to both side surfaces of the plurality of semiconductor patterns, respectively, a contact structure connected to first source/drain patterns through the insulating base layer, a sidewall insulating film disposed between an upper portion of the contact structure and an upper portion of the insulating base layer and extending onto a region of a portion of the gate structure located below a lowermost semiconductor pattern among the plurality of semiconductor patterns, and a power transmission line disposed on a lower surface of the insulating base layer and connected to the contact structure.

## Description

### BACKGROUND

Some inventive concepts relate to a semiconductor device.

As demand for high performance, high speed, and/or multifunctionality of semiconductor devices has increased, the degree of integration of semiconductor devices has increased. In accordance with the trend for high integration of semiconductor devices, semiconductor devices having a backside power delivery network (BSPDN) structure in which a power rail is disposed on the back of a wafer have been developed. In addition, in order to overcome limitations in operating characteristics due to a size reduction of planar metal oxide semiconductor field-effect transistors (MOSFETs), efforts have been made to develop semiconductor devices having channels with a three-dimensional structure.

### SUMMARY

Various example embodiments provide a semiconductor device having improved electrical characteristics and reliability.

In some example embodiments, a semiconductor device includes an insulating base layer having an insulating pattern extending in a first direction, a plurality of semiconductor patterns stacked on the insulating pattern and spaced apart from each other in a direction, perpendicular to an upper surface of the insulating base layer, a gate structure extending in a second direction, intersecting the first direction, the gate structure surrounding the plurality of semiconductor patterns, first and second source/drain patterns on the insulating pattern and respectively connected to both side surfaces of the plurality of semiconductor patterns in the first direction, an interlayer insulating layer covering the first and second source/drain patterns, a first contact structure connected to the first source/drain pattern through the insulating base layer, and a first sidewall insulating film between an upper portion of the first contact structure and an upper portion of the insulating pattern, the first sidewall insulating film extending to cover a side surface of a portion of the gate structure located below a lowermost semiconductor pattern among the plurality of semiconductor patterns.

In some example embodiments, a semiconductor device includes an insulating base layer, a plurality of semiconductor patterns stacked on a region of the insulating base layer and spaced apart from each other in a vertical direction, first and second source/drain patterns respectively connected to both side surfaces of the plurality of semiconductor patterns in a first direction, a gate structure extending in a second direction, intersecting the first direction, the gate structure surrounding the plurality of semiconductor patterns, an interlayer insulating layer covering the first and second source/drain patterns, a first contact structure connected to the first source/drain pattern through the insulating base layer, a second contact structure connected to the second source/drain pattern through the interlayer insulating layer, a first sidewall insulating film surrounding an upper portion of the first contact structure, extending from a side surface of the region of the insulating base layer, and having an upper end on a level lower than a level of a lower surface of a lowermost semiconductor pattern among the plurality of semiconductor patterns, a vertical insulating pattern connected to a lower surface of the second source/drain pattern, the vertical insulating pattern arranged in the insulating base layer, and a second sidewall insulating film surrounding an upper portion of the vertical insulating pattern, the second sidewall insulating film arranged on a level, which is the same as a level of the first sidewall insulating film.

In some example embodiments, a semiconductor device includes an insulating base layer, a plurality of semiconductor patterns stacked on the insulating base layer and spaced apart from each other, a gate structure surrounding the plurality of semiconductor patterns, first and second source/drain patterns on the insulating base layer and connected to both side surfaces of the plurality of semiconductor patterns, respectively, a contact structure connected to first source/drain patterns through the insulating base layer, a sidewall insulating film between an upper portion of the contact structure and the portion of the insulating base layer, the sidewall insulating film extending onto a region of a portion of the gate structure located below a lowermost semiconductor pattern among the plurality of semiconductor patterns, and a power transmission line on a lower surface of the insulating base layer and connected to the contact structure.

At least some of the above and other features of the invention are set out in the claims.

### BRIEF DESCRIPTION OF DRAWINGS

The above and other aspects, features, and advantages of the present inventive concepts will be more clearly understood from the following detailed description, taken in conjunction with the accompanying drawings, in which:
FIG. 1 is a plan view illustrating a semiconductor device according to an example embodiment of the present inventive concepts;
FIG. 2 is a cross-sectional view of the semiconductor device of FIG. 1, taken along line I-I';
FIGS. 3A and 3B are cross-sectional views of the semiconductor device of FIG. 1, taken along lines II1-II1' and II2-II2', respectively;
FIGS. 4A and 4B are partially enlarged views illustrating portions "A" and "B" of the semiconductor device of FIG. 2, respectively;
FIGS. 5A and 5B are cross-sectional views illustrating semiconductor devices according to various example embodiments of the present inventive concepts, respectively;
FIG. 6 is a cross-sectional view illustrating a semiconductor device according to an example embodiment of the present inventive concepts;
FIGS. 7A to 7H are cross-sectional views of each major process to illustrate some processes (e.g., sidewall insulating film and source/drain pattern formation processes) of a method of manufacturing a semiconductor device according to an example embodiment of the present inventive concepts;
FIGS. 8A to 8C are partially enlarged views illustrating partial regions A1, A2, and A3 of FIGS. 7F to 7H, respectively;
FIGS. 9A to 9H are cross-sectional views of each major process to illustrate another partial process (e.g., contact formation process) of the method of manufacturing a semiconductor device according to an example embodiment of the present inventive concepts;
FIGS. 10A and 10B are partially enlarged views illustrating partial regions A4 and A5 of FIGS. 9D and 9H, respectively; and
FIGS. 11A to 11E are cross-sectional views of each major process to illustrate another partial process (e.g., contact formation process) of the method of manufacturing a semiconductor device according to an example embodiment of the present inventive concepts.

### DETAILED DESCRIPTION

Hereinafter, some example embodiments of the present inventive concepts will be described with reference to the accompanying drawings.

As described herein, an element that is "on" another element may be above or beneath or adjacent (e.g., horizontally adjacent) to the other element. An element that is on another element may be directly on the other element, such that the element is in direct contact with the other element. An element that is on another element may be indirectly on the other element, such that the element is isolated from direct contact with the other element by one or more interposing spaces and/or structures. The reference to lower or lowermost may be a reference to a direction from and perpendicular to the upper surface of the insulating base layer, or vertical direction.

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

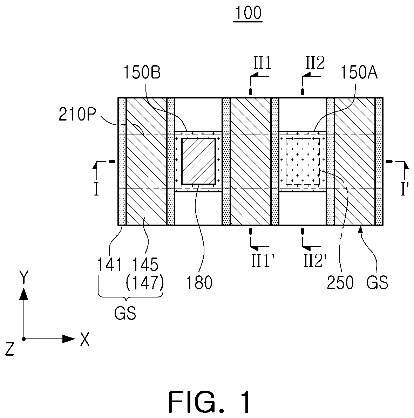

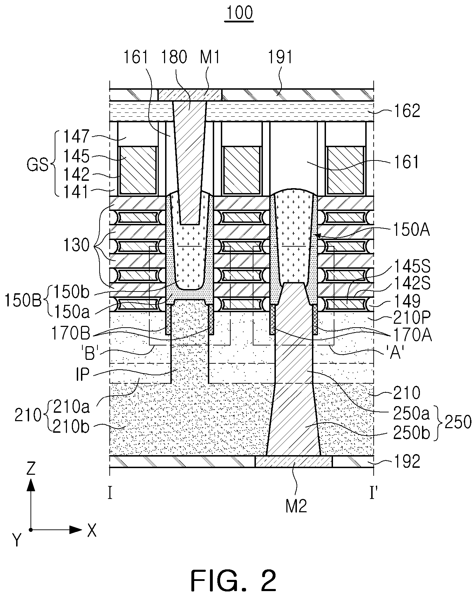

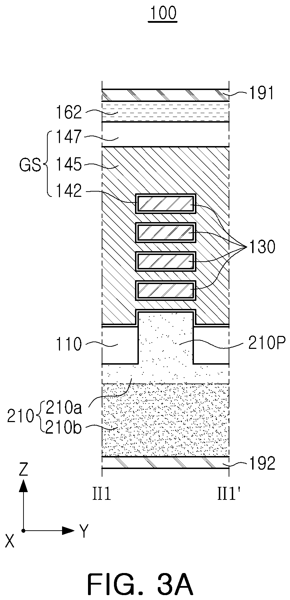

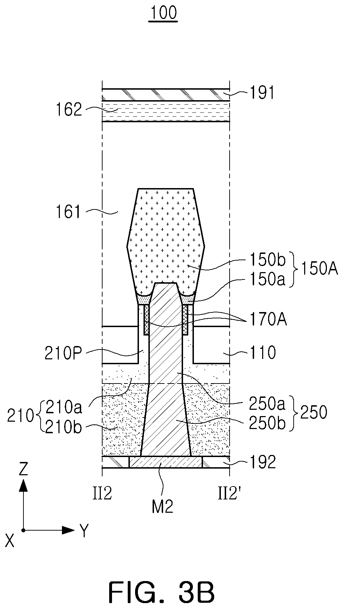

FIG. 1 is a plan view illustrating a semiconductor device according to an example embodiment of the present inventive concepts, FIG. 2 is a cross-sectional view of the semiconductor device of FIG. 1, taken along line I-I', and FIGS. 3A and 3B are cross-sectional views of the semiconductor device of FIG. 1, taken along lines II1-II1' and II2-II2', respectively;

Referring to FIGS. 1, 2, 3A, and 3B, a semiconductor device 100 according to some example embodiment includes an insulating base layer 210, a plurality of semiconductor patterns 130 stacked on a region of the insulating base layer 210 and spaced apart from each other in a vertical direction (e.g., a Z-direction), first and second source/drain patterns 150A and 150B connected to both side surfaces of the plurality of semiconductor patterns 130 in a first direction (e.g., an X-direction), respectively, and a gate structure GS extending in the second direction (e.g., a Y-direction) intersecting the first direction (e.g., the X-direction) and surrounding the plurality of semiconductor patterns 130.

In some example embodiments, the insulating base layer 210 extends in the first direction (e.g., the X-direction) and has an insulating pattern 210P (e.g., protruding insulating pattern). The plurality of semiconductor patterns 130 are stacked on a region of the insulating pattern 210P and spaced apart from each other. The gate structure GS may extend to intersect the insulating pattern 210P on the insulating base layer 210. The first and second source/drain patterns 150A and 150B may be disposed on regions of the insulating pattern 210P located on both sides of the gate structure GS (e.g., refer to FIG. 2).

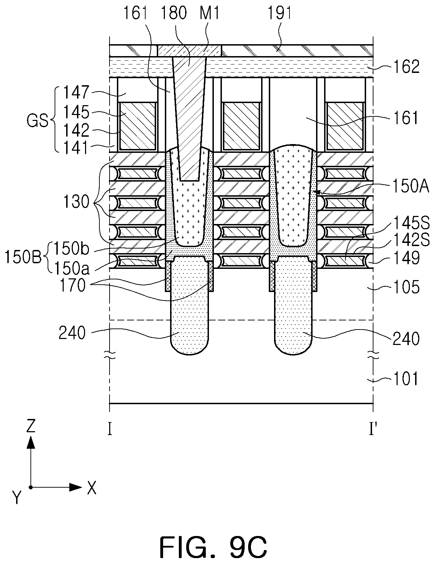

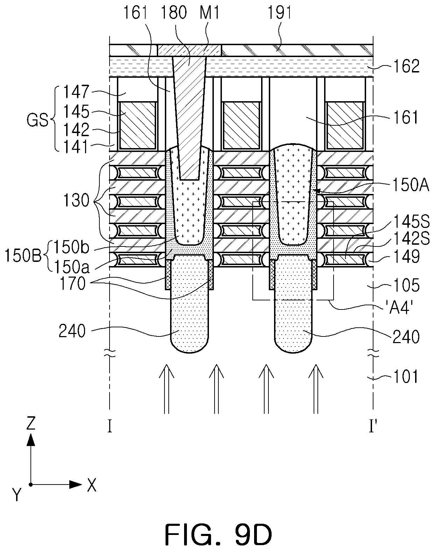

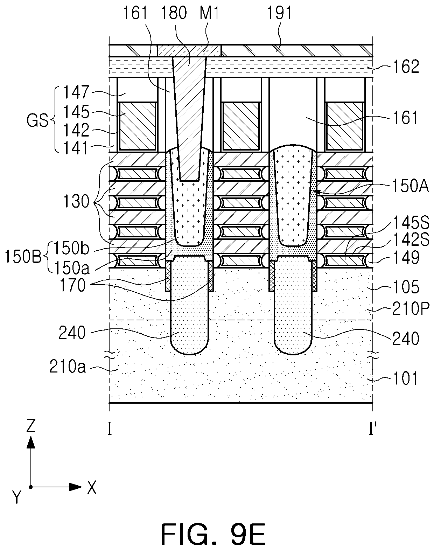

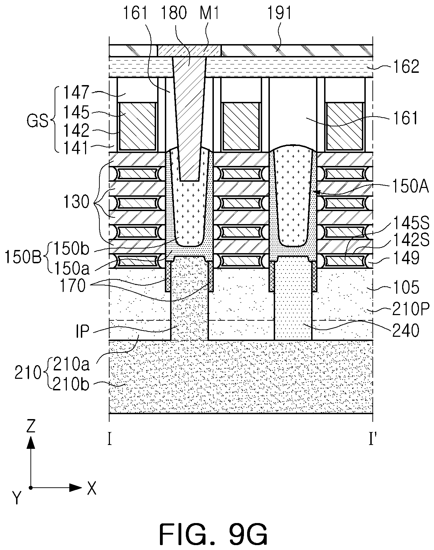

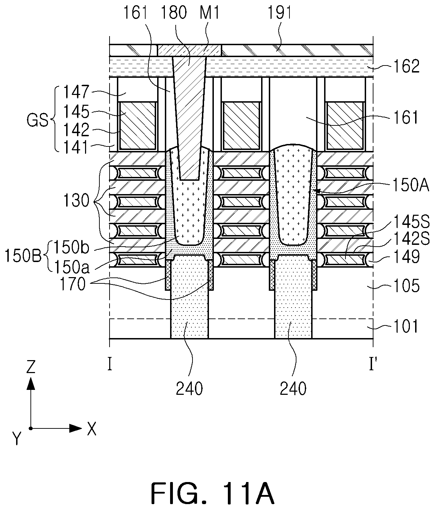

The insulating base layer 210 may be a layer formed through an additional process (e.g., refer to FIGS. 9D and 9E) after removing the substrate (e.g., refer to '101' of FIG. 9C) including a semiconductor material in a series of manufacturing processes for semiconductor devices or may be a layer formed by oxidizing the substrate. The insulating base layer 210 includes an insulating material, such as an oxide or a nitride. For example, the insulating base layer 210 may include spin-on hardmask (SOH), flowable oxide (FOX), tonsen silazen (TOSZ), undoped silica glass (USG), borosilica glass (BSG), phosphosilaca glass (PSG), borophosphosilica glass (BPSG), plasma enhanced tetraethylortho silicate (PETEOS), fluoride silicate glass (FSG), high density plasma (HDP) oxide, plasma enhanced oxide (PEOX), flowable CVD (FCVD) oxide, or combinations thereof, but example embodiments are limited thereto. The insulating base layer 210 may be formed using a chemical vapor deposition (CVD) process, a flowable-CVD process, or a spin coating process. In some example embodiments, the insulating base layer 210 may include a first insulating material layer 210a and a second insulating material layer 210b. The first insulating material layer 210a and the second insulating material layer 210b may include the same material, but may be formed through different processes (e.g., refer to FIGS. 9E and 9G). In some example embodiments, the insulating base layer 210 may have a single-layer structure (e.g., refer to FIGS. 11A to 11E).

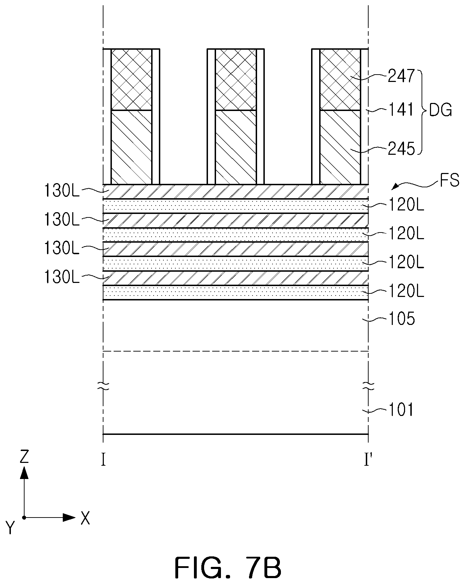

The insulating pattern 210P of the insulating base layer 210 may be understood as a portion corresponding to a fin-type active pattern (e.g., 105 in FIG. 7B) of the semiconductor substrate. The insulating pattern 210P may be formed in the process of replacing the aforementioned semiconductor substrate with the insulating base layer 210.

Referring to FIGS. 3A and 3B, a device isolation layer 110 may define the insulating pattern 210P on the insulating base layer 210. The device isolation layer 110 may be disposed on the insulating base layer 210 to cover both side surfaces of the insulating pattern 210P. An upper portion of the insulating pattern 210P may be exposed from the upper surface of the device isolation layer 110.

As described above, the plurality of semiconductor patterns 130 may be stacked and spaced apart from each other on the insulating pattern 210P to serve as a channel layer. As illustrated in FIG. 2, both side surfaces of the plurality of semiconductor patterns 130 in the first direction (e.g., the X-direction) may be connected to the first and second source/drain patterns 150 located on the insulating pattern 210P, respectively.

The plurality of semiconductor patterns 130 may have a width equal to or similar to a width of the insulating pattern 210P in the second direction (e.g., the Y-direction). In some example embodiments, the width of the plurality of semiconductor patterns 130 may be slightly different. For example, the width of the highest and lowermost semiconductor patterns may be greater than the width of the semiconductor patterns located therebetween.

The plurality of semiconductor patterns 130 may include a semiconductor material that may provide a channel region for a transistor. For example, the plurality of semiconductor patterns 130 may include at least one of silicon (Si), silicon germanium (SiGe), and germanium (Ge). In some example embodiments, the plurality of semiconductor patterns 130 may be a silicon semiconductor. In some example embodiments, the plurality of semiconductor patterns 130 is illustrated as four semiconductor patterns, but the number and shape may vary.

As illustrated in FIGS. 2 and 3A, the gate structure GS employed in some example embodiments may include a gate electrode 145 extending in the second direction (e.g., the Y-direction) and surrounding the plurality of semiconductor patterns 130, a gate insulating film 142 disposed between the gate electrode 145 and the plurality of semiconductor patterns 130, gate spacers 141 disposed on both side surfaces of the gate electrode 145 portion located on the uppermost semiconductor pattern, and a gate capping layer 147 disposed on the gate electrode 145 between the gate spacers 141.

The gate electrode 145 may include a conductive material. For example, the gate electrode 145 may include at least one of W, Ti, Ta, Mo, TiN, TaN, WN, TiON, TiAlC, TiAlN, and TaAlC, but example embodiments are not limited thereto. In some example embodiments, the gate electrode 145 may include a semiconductor material, such as doped polysilicon. At least one of the gate electrodes 145 may include a multilayer structure formed of different materials.

The gate insulating film 142 may include a dielectric material. For example, the gate insulating film 142 may include oxide, nitride, or a high-k material. The high-k material may refer to a dielectric material having a dielectric constant higher than that of silicon oxide (SiO₂), and the high-k material may be any one of, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃), but example embodiments are not limited thereto. In some example embodiments, the gate insulating film 142 may include two or more different dielectric films.

The gate spacers 141 may include an insulating material. For example, the gate spacers 141 may include at least one of silicon oxide, silicon nitride, and silicon oxynitride. In some example embodiments, the gate spacers 141 may include a multilayer structure formed of different materials. The gate capping layer 147 may include, for example, silicon nitride, silicon oxynitride, silicon carbonitride, or silicon oxycarbonitride.

The gate structure GS, according to some example embodiments, may include internal spacers 149. The internal spacers 149 may be disposed between the plurality of semiconductor patterns 130 and on both sides of the gate electrode portions 145S located between the lowermost semiconductor pattern 130U and the insulating pattern 210P. The gate electrode portions 145S may be surrounded by gate insulating portions 142S in the first direction (e.g., the X-direction). The gate electrode portions 145S and the gate insulating portions 142S may be spaced apart from the first and second source/drain patterns 150A and 150B by the internal spacers 149. The internal spacers 149 may have convex side surfaces facing the gate electrode portions 145S, but example embodiments are not limited thereto. For example, the internal spacers 149 may include a low dielectric material, such as oxide, nitride, and oxynitride.

As illustrated in FIG. 2, the first and second source/drain patterns 150A and 150B may be included in a partial region of the insulating pattern 210P located on both sides of the gate structures GS. Regions of the insulating pattern 210P in which the first and second source/drain patterns 150A and 150B are formed may be slightly recessed regions. As described above, the first and second source/drain patterns 150A and 150B may be respectively connected to both side surfaces of the plurality of semiconductor patterns 130, which are channel regions.

Referring to FIGS. 2 and 3A, the first and second source/drain patterns 150A and 150B employed in some example embodiments include a first epitaxial layer 150a and a second epitaxial layer 150b disposed on the first epitaxial layer 150a. In some example embodiments, the first epitaxial layer 150a may directly contact the side surfaces of the plurality of semiconductor patterns 130.

In some example embodiments, the first epitaxial layer 150a and the second epitaxial layer 150b may include different materials. For example, in the case of a PMOSFET, the first and second epitaxial layers 150a and 150b may include SiGe having different Ge components (e.g., the second epitaxial layer 150b includes a higher Ge content), or the first and second epitaxial layers 150a and 150b may include Si and SiGe, respectively. However, in the case of a NMOSFET, the first and second epitaxial layers 150a and 150b may both include Si. In some example embodiments, the first epitaxial layer 150a and the second epitaxial layer 150b may include different types of impurities or the same impurities at different concentrations.

The semiconductor device 100 according to some example embodiments may include a first interlayer insulating layer 161 disposed on the device isolation layer 110 to cover the first and second source/drain patterns 150A and 150B and a second interlayer insulating layer 162 covering the gate structure GS on the first interlayer insulating layer 161. For example, the first and second interlayer insulating layers 161 and 162 may include FOX, TOSZ, USG, BSG, PSG, BPSG, PETEOS, FSG, HDP oxide, PEOX, FCVD oxide, or combinations thereof, but example embodiments are not limited thereto. The first and second interlayer insulating layers 161 and 162 may each be formed using chemical vapor deposition, flowable CVD process, or spin-coating process.

Referring to FIG. 2, the semiconductor device 100, according to some example embodiments, may include a first contact structure 250 connected to the first source/drain pattern 150A and a second contact structure 180 connected to the second source/drain pattern 150B.

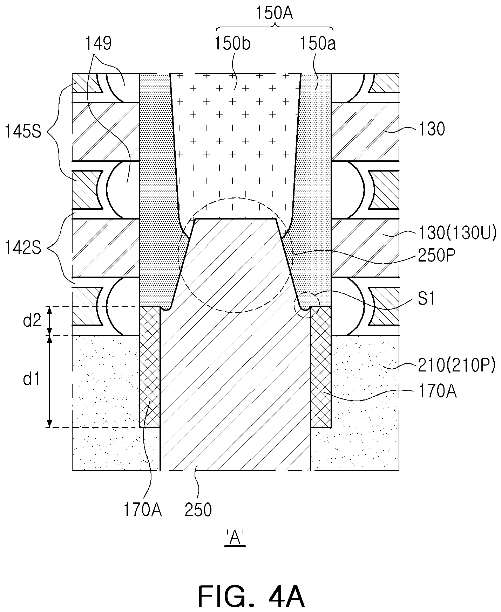

The first contact structure 250 may be connected to the first source/drain pattern 150A through the insulating base layer 210 portion immediately below the first source/drain pattern 150A. The first contact structure 250 may extend inwardly from a lower surface of the first source/drain pattern 150A. For example, as illustrated in FIGS. 2 and 4A, an upper portion 250P of the first contact structure 250 may be in contact with the second epitaxial layer 150b.

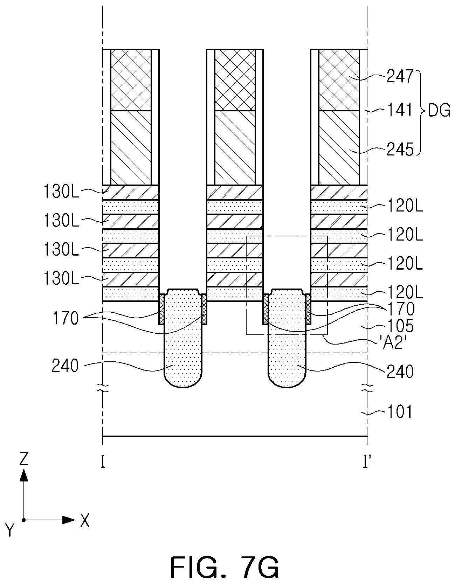

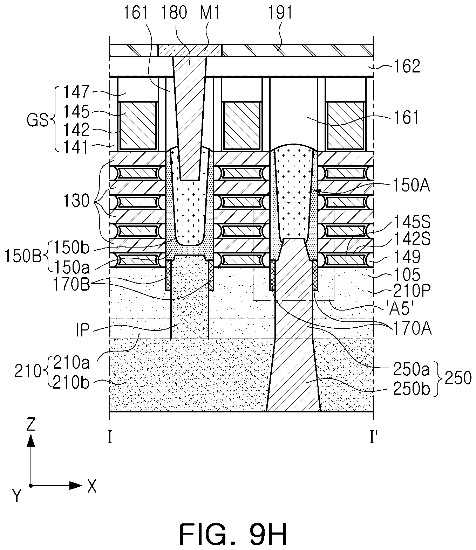

In some example embodiments, the first contact structure 250 includes a first portion 250a penetrating through the first insulating material layer 210a and a second portion 250b penetrating through the second insulating material layer 250b. The first portion 250a of the first contact structure 250 may be formed in a space previously secured by a vertical sacrificial pattern (e.g., 240 in FIG. 7G), which is a contact align element (e.g., refer to FIG. 9H). The second portion 250b of the first contact structure 250 may be formed through a hole structure formed from a lower surface of the second insulating material layer 210b. Accordingly, in some example embodiments, the first contact structure 250 may have a discontinuous side surface. The side surface of the first portion 250a may be discontinuously connected to the side surface of the second portion 250b. Here, "discontinuously connected" may mean that the side surfaces of the first portion 250a and the second portion 250b are connected to each other, but the profile of the side surface of the first portion 250a and the profile of the side surface of the second portion 250b are different. For example, it may refer to a case in which, as illustrated in FIGS. 2 and 3B, the side surface of the first portion 250a and the side surface of the second portion 250b have different slopes or the slopes differ at the point where the side surfaces are connected discontinuously.

In some example embodiments, a first sidewall insulating film 170A may be disposed between an upper portion of the first contact structure 250 and an upper portion of the insulating base layer 210 (in at least some embodiments, the insulating pattern 210P). The first sidewall insulating film 170A may surround the upper portion of the first contact structure 250.

FIG. 4A is a partially enlarged view of "A" of the semiconductor device of FIG. 2.

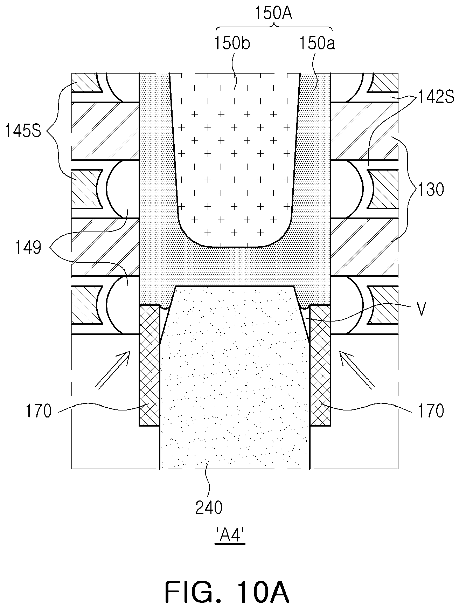

Referring to FIG. 4A, along with FIG. 2, the first sidewall insulating film 170A is disposed between the upper portion of the first contact structure 250 and the upper portion of the insulating base layer 210 (in at least some embodiments the insulating pattern 210P), thereby effectively preventing (or reducing) loss of the first source/drain pattern 150A when a semiconductor substrate (e.g., refer to FIGS. 9D and 10A) is removed. To this end, the first sidewall insulating film 170A may cover the upper portion of the insulating pattern 210P with a predetermined width d1. For example, the width d1 covered by the first sidewall insulating film 170 may be in the range of 0.5 nm to 10 nm.

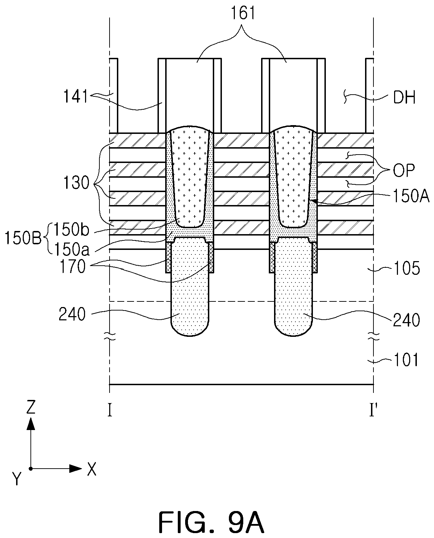

The first sidewall insulating film 170A employed in some example embodiments may extend to cover the side surfaces of the portions 142S and 145S of the gate structure located below the lowermost semiconductor pattern 130U among the plurality of semiconductor patterns 130. This first sidewall insulating film 170A may prevent (or reduce) damage to a vertical sacrificial pattern 240 when a dummy gate structure DG is removed (e.g., refer to FIG. 9A). To this end, the first sidewall insulating film 170A may cover the portion of the gate structure with a predetermined width d2. For example, the width d2 covered by the first sidewall insulating film 170A may be in the range of 0.5 nm to 5 nm.

The upper end of the first sidewall insulating film 170A may be located on a level lower than that of a lower surface of the lowermost semiconductor pattern 130U among the plurality of semiconductor patterns 130. The first sidewall insulating film 170A may not interfere with contact between the first source/drain pattern 150A and the lowermost semiconductor pattern 130U. For such a blocking effect, for example, a thickness t of the first sidewall insulating film 170A may be in the range of 0.5 nm to 3 nm.

Referring to FIG. 4A, an upper surface of the first contact structure 250 may be located on a level higher than that of the upper end of the first sidewall insulating film 170A. As described above, the upper portion 250P of the first contact structure 250 may be in contact with the second epitaxial layer 150b. A portion S1 of the first contact structure 250 adjacent to the upper end of the first sidewall insulating film (or an edge region of the upper surface of the first contact structure 250) may have a concave portion lower than the upper end of the first sidewall insulating film 170A. As such, the upper surface of the first contact structure 250 may overlap the lowermost semiconductor pattern 130U in a horizontal direction or may be located on a level higher than that of the lowermost semiconductor pattern 130U.

The insulating base layer 210 (e.g., the first insulating material layer 210a) located immediately below the second source/drain pattern 150B connected to the second contact structure 180 may include a vertical insulating pattern IP. The vertical insulating pattern IP may be connected to a lower surface of the second source/drain pattern 150B. The vertical insulating pattern IP may be formed in a space secured by the vertical sacrificial pattern (e.g., 240 in FIG. 7G), which is a contact alignment element (e.g., refer to FIGS. 9E to 9G). In some example embodiments, the second sidewall insulating film 170B may surround an upper portion of the vertical insulating pattern IP.

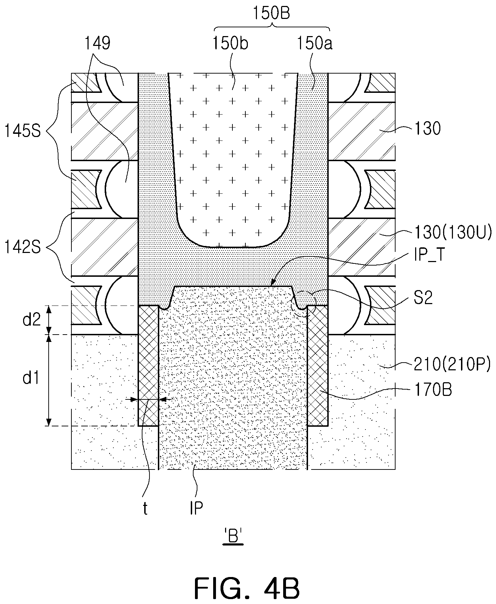

FIG. 4B is a partially enlarged view of "B" of the semiconductor device of FIG. 2.

Referring to FIG. 4B, along with FIG. 2, similar to the first sidewall insulating film 170A, the second sidewall insulating film 170B may be disposed between an upper portion of the vertical insulating pattern IP and the insulating base layer 210 (e.g., the insulating pattern 210P). Due to this arrangement, the second sidewall insulating film 170B, similarly to the first sidewall insulating film 170A, may effectively prevent (or reduce) loss of the second source/drain pattern 150B when removing the second semiconductor substrate (e.g., refer to FIGS. 9D and FIG. 10A). To this end, the second sidewall insulating film 170B may cover the upper portion of the insulating pattern 210P with a predetermined width d1.

Similarly to the first sidewall insulating film 170A, the second sidewall insulating film 170B employed in some example embodiments may extend to cover side surfaces of the portions 142S and 145S of the gate structure located below the lowermost semiconductor pattern 130U among the plurality of semiconductor patterns 130. Through this arrangement, the second sidewall insulating film 170B may prevent (or reduce) damage to the vertical sacrificial pattern 240 when the dummy gate structure DG is removed (e.g., refer to FIG. 9A). To this end, the second sidewall insulating film 170B may cover the portion of the gate structure with a predetermined width d2. The second sidewall insulating film 170B may have a thickness corresponding to the thickness t of the first sidewall insulating film 170A.

In some example embodiments, an upper surface IP_T of the vertical insulating pattern IP is located on a level lower than that of the upper surface of the first contact structure 250 (e.g., refer to FIG. 2) but may be on a level higher than that of an upper end of the second sidewall insulating film 170B. An edge region S2 of the upper surface IP_T of the vertical insulating pattern IP may have a portion lower than the upper end of the second sidewall insulating film 170B.

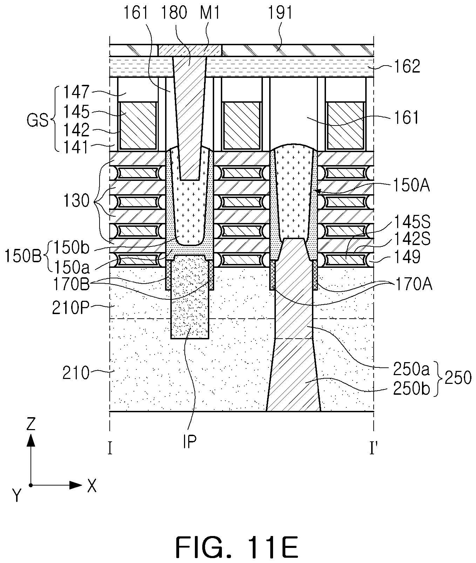

The vertical insulating pattern IP employed in some example embodiments may be a partial region of the second insulating material layer 210b. The second insulating material layer 210b may include the same material as the first insulating material layer 210a. In some example embodiments, the vertical insulating pattern IP may include a material different from that of the insulating base layer 210. For example, the vertical insulating pattern IP may be embedded in the insulating base layer 210 (e.g., refer to FIG. 11E).

The first and second contact structures 250 and 180 may each include a contact plug and a barrier layer surrounding the contact plug. For example, the contact plug may include Cu, Co, Mo, Ru, W, or alloys thereof, but example embodiments are not limited thereto. For example, the barrier may include Ta, TaN, Mn, MnN, WN, Ti, TiN, or combinations thereof, but example embodiments are not limited thereto.

The semiconductor device 100 according to some example embodiments has a double-sided interconnection structure including a first interconnection structure and a second interconnection structure. The first interconnection structure is provided on an upper surface of the semiconductor device 100, and the second interconnection structure is provided on a lower surface of the semiconductor device 100.

The first interconnection structure may include a first interconnection insulating layer 191 and an upper interconnection line M1 disposed in the first interconnection insulating layer 191. Similarly, the second interconnection structure may include a second interconnection insulating layer 192 and a lower interconnection line M2c disposed within the second interconnection insulating layer 192. For example, the first and second interconnection insulating layers 191 and 192 may include silicon oxide, silicon oxynitride, SiOC, SiCOH, or combinations thereof. For example, the upper and lower interconnection lines M1 and M2 may include copper or a copper-containing alloy. The lower interconnection line M2 may be provided as a power line for power transmission, and may supply power for device operation to the first source/drain pattern 150A through the first contact structure 250.

In some example embodiments, the sidewall insulating film may be introduced into the upper portion of the first contact structure and/or the vertical insulating pattern, thereby preventing (or reducing) damage to a contact alignment portion when a dummy gate structure is removed and/or loss of source/drain patterns when the substrate is removed. This sidewall insulating film and peripheral components thereof may be variously changed.

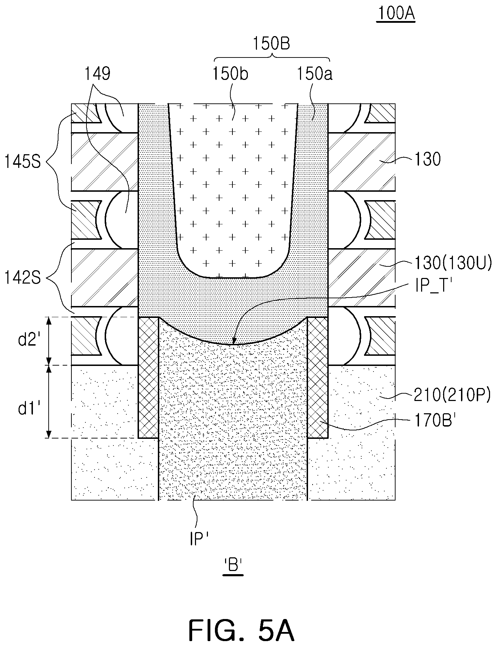

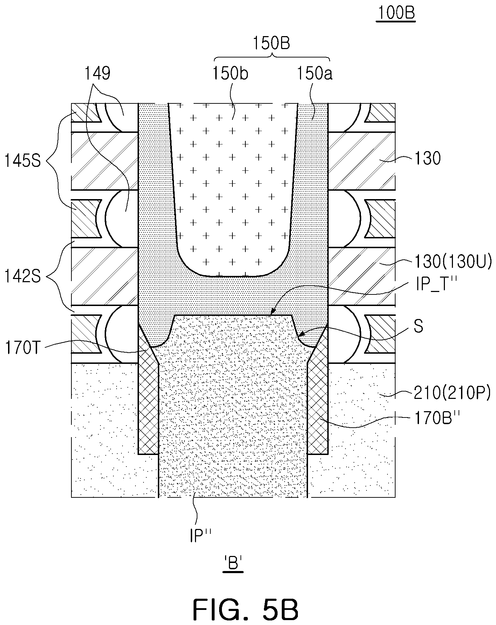

FIGS. 5A and 5B are cross-sectional views illustrating semiconductor devices according to various example embodiments of the present inventive concepts, respectively.

Referring to FIG. 5A, a semiconductor device 100A according to some example embodiments may be understood as being similar to the semiconductor device 100 illustrated in FIGS. 1 to 4B, except that an upper surface IP_T' of a vertical insulating pattern IP' has a level lower than that of the upper end of the second sidewall insulating film 170B. In addition, unless otherwise stated, the components of some example embodiments may be understood with reference to descriptions of the same or similar components of the semiconductor device 100 illustrated in FIGS. 1 to 4B.

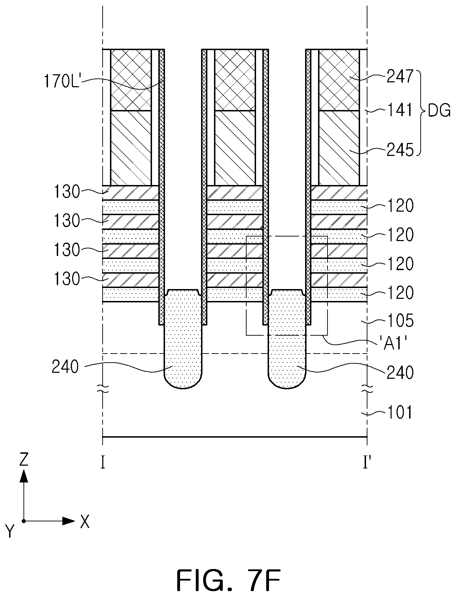

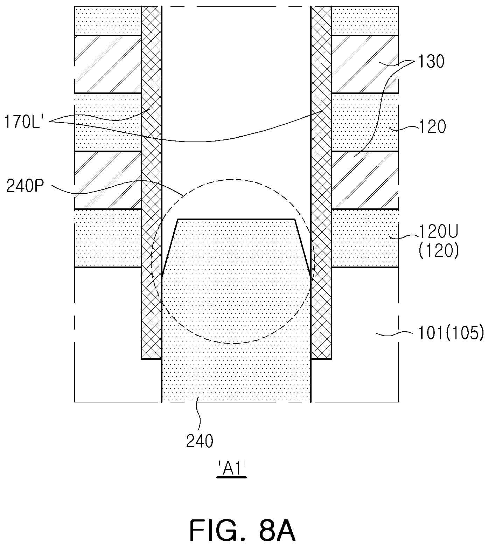

The upper surface IP_T' of the vertical insulating pattern IP' employed in some example embodiments may be lower than an upper end of a second sidewall insulating film 170B'. In general, the vertical sacrificial pattern 240 may have a crystallographically protruding upper surface during an overgrowth process (e.g., refer to FIGS. 7F and 8A). As a result, similar to the shape of the vertical sacrificial pattern 240, the upper surface of the vertical insulating pattern may also protrude. In some example embodiments, before removing the exposed portion of the blocking insulating layer 170L (e.g., refer to FIG. 7G), an etching process may be additionally applied to remove or lower the protruding portion of the vertical sacrificial pattern 240. As a result, as illustrated in FIG. 5A, the upper surface IP_T' of the vertical insulating pattern IP may have a level lower than the upper end of the second sidewall insulating film 170B'. For example, a point corresponding to the center of the upper surface IP_T' of the vertical insulating pattern IP in the first direction (e.g., the X-direction) may have a level lower than the uppermost end of the second sidewall insulating film 170B'. In some example embodiments, the vertical insulating pattern IP' may have a concave upper surface IP_T'. For example, the lower surface of the second source/drain pattern 250B may have a convex shape toward the second interconnection structure.

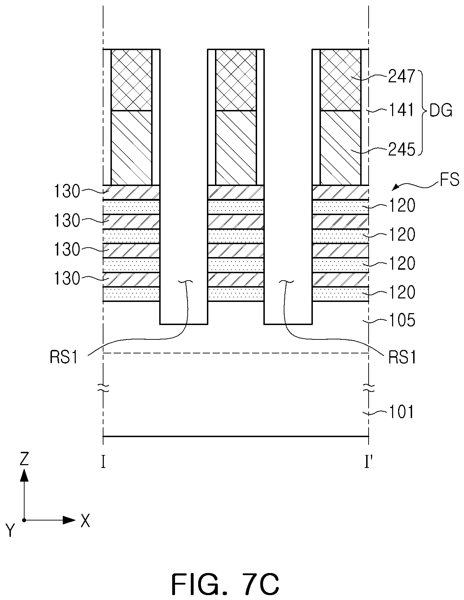

A width d1' of the upper portion of the insulating pattern 210P covered by the second sidewall insulating film 170B' may be increased. The change in width d1' may be realized by adjusting a depth of a first recess RS1 (e.g., refer to FIG. 7C). A width d2' of the portion of the gate structure covered by the second sidewall insulating film 170B' may also be adjusted. This change in width d2' may be realized by adjusting an overgrowth height of the vertical sacrificial pattern 240 (e.g., refer to FIG. 7F).

Referring to FIG. 5B, the semiconductor device 100B, according to some example embodiments, may be understood as being similar to the semiconductor device 100 illustrated in FIGS. 1 to 4B, except that an upper end region 170T of the second sidewall insulating film 170B" is thinner than other regions and an edge region S of the upper surface IP_T" has a relatively deep concave region. In addition, unless otherwise stated, components of some example embodiments may be understood with reference to descriptions of the same or similar components of the semiconductor device 100 illustrated in FIGS. 1 to 4B.

Similar to previous example embodiments (e.g., refer to FIG. 4B), the upper surface IP_T" of the vertical insulating pattern IP has a level higher than that of the upper end of the second sidewall insulating film 170B, and the edge region S of the upper surface IP_T" of the vertical insulating pattern IP" may have a region lower than the upper surface. However, the edge region S may have a concave region that is relatively deeper than that of previous example embodiments. In addition, the upper end 170T of the second sidewall insulating film has a region decreasing upwardly. This profile may occur during a selective removal process of the blocking insulating film.

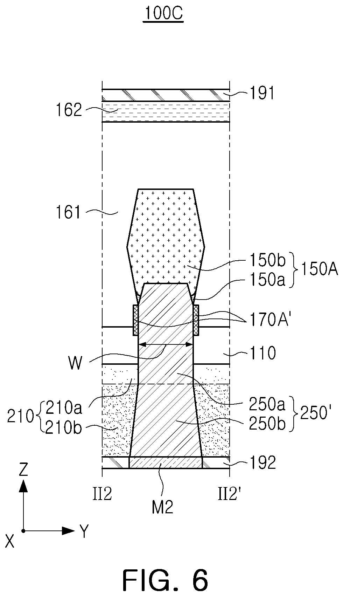

FIG. 6 is a cross-sectional view illustrating a semiconductor device according to some example embodiments of the present inventive concepts.

Referring to FIG. 6, a semiconductor device 100C, according to some example embodiments, may be understood as being similar to the semiconductor device 100 illustrated in FIGS. 1 to 4B, except that the width W of a first contact structure 250' expands in the second direction (e.g., the Y-direction). In addition, unless otherwise stated, components of some example embodiments may be understood with reference to descriptions of the same or similar components of the semiconductor device 100 illustrated in FIGS. 1 to 4B.

The first contact structure 250' employed in some example embodiments may have the width W expanding in the second direction (e.g., the Y-direction), unlike the previous example embodiment (e.g., FIG. 3B). The width of the first contact structure 250' in the second direction may correspond to the width of the insulating pattern (e.g., 210P in FIG. 3B) in the second direction. In this manner, by expanding the width W of the first contact structure 250', a contact area with the first source/drain pattern 150A may increase. As a result, contact resistance of the first contact structure 250' and the first source/drain pattern 150A may be lowered.

As illustrated in FIG. 6, both side surfaces of the first contact structure 250' may partially contact the device isolation layer 110. For example, the first sidewall insulating film 170A' has a portion between the first contact structure 250' and an upper portion of the device isolation layer 110 by. The first sidewall insulating film 170A' may extend to a lower end of the first source/drain pattern 150A.

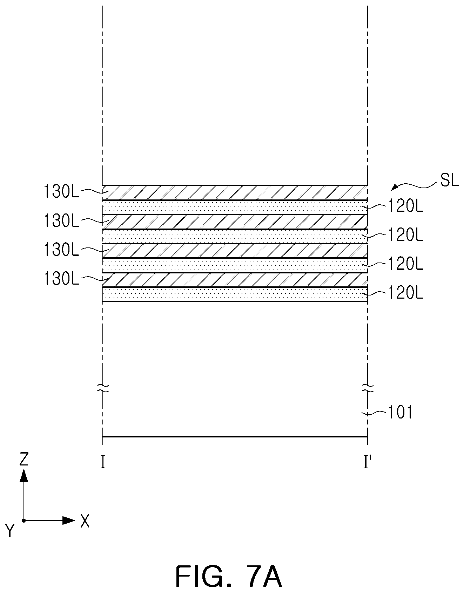

FIGS. 7A to 7H are cross-sectional views of major processes illustrating some processes (e.g., sidewall insulating film and source/drain pattern formation processes) of a method of manufacturing a semiconductor device according to some example embodiments of the present inventive concepts, and FIGS. 8A to 8C are partially enlarged views illustrating some regions A1, A2, and A3 in FIGS. 7F to 7H.

Referring to FIG. 7A, sacrificial layers 120L and semiconductor layers 130L may be alternately stacked on the substrate 101.

The substrate 101 may include a semiconductor material, for example, a group IV semiconductor, a group III-V compound semiconductor, or a II-VI compound semiconductor. For example, the group IV semiconductor may include silicon (Si), germanium (Ge), or silicon germanium (SiGe). The substrate 101 may include a bulk wafer, an epitaxial layer, or a silicon-on-insulator (SOI) layer, but example embodiments are not limited thereto.

A semiconductor stack SL may be formed by alternately stacking sacrificial layers 120L and semiconductor layers 130L on the substrate. The sacrificial layers 120L may have a composition different from that of the semiconductor layers 130L to have a selectivity with the semiconductor layers 130L. In some example embodiments, the sacrificial layers 120L and the semiconductor layers 130L may be implemented by differing germanium composition ratios (e.g., 0 to 60%). For example, the semiconductor layers 130L provided as a channel region may include silicon. The sacrificial layers 120L may include silicon germanium having a relatively high germanium concentration (e.g., 15% or more).

Next, referring to FIG. 7B, the semiconductor stack SL is patterned into a plurality of fin-shaped structures FS extending in the first direction (e.g., the X-direction), and a plurality of dummy gate structures DG extending in the second direction (e.g., the Y-direction) are formed.

In the process of forming the fin-type structure FS, the substrate 101 along with the sacrificial layers 120L and the semiconductor layers 130L may be partially removed to form the fin-type active pattern 105. Subsequently, the device isolation layer 110 is formed in the removed region (e.g., refer to FIGS. 1, 3A, and 3B).

Thereafter, dummy gate structures DG and gate spacer layers 141 extending in the second direction (e.g., the Y-direction) across the fin-type structure FS may be formed. The dummy gate structure DG defines a formation region of the gate structure GS. The dummy gate structure DG may be arranged at constant pitches in the first direction (e.g., the X-direction).

The dummy gate structure DG may include sacrificial gate layers 245 and a mask pattern 247 that are sequentially stacked. The sacrificial gate layer 245 may be patterned using a mask pattern 247. For example, the sacrificial gate layer 245 may include polysilicon. The sacrificial gate layer 245 may include multiple layers. The mask pattern 247 may include silicon oxide and/or silicon nitride. The gate spacers 141 may be formed on both sidewalls of the dummy gate structures DG. As described above, the gate spacers 141 may be formed of a low-k material and may include, for example, at least one of SiO, SiN, SiCN, SiOC, SiON, and SiOCN.

Thereafter, referring to FIG. 7C, the fin-type structure FS region exposed from the dummy gate structures DG may be removed to form first recesses RS1.

Using the dummy gate structures DG and the gate spacers 141 as masks, exposed regions of the fin-type structure FS may be removed to form first recesses RS1. In this process, the semiconductor patterns 130 may have a channel length in the first direction (e.g., the X-direction). A depth of the first recesses RS1 may be adjusted so that at least a portion of the fin-type active pattern 105 is removed. The exposed sidewall region of the fin-type active pattern 105 may be provided as a substrate region covered by a sidewall insulating film (e.g., 170 in FIG. 7A) in a subsequent process.

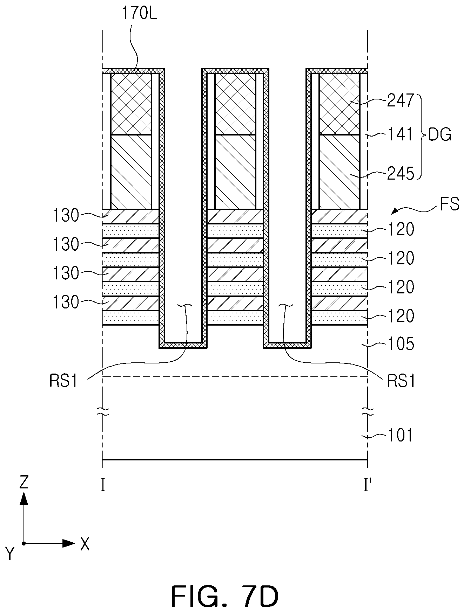

Thereafter, referring to FIG. 7D, the blocking insulating layer 170L may be formed conformally.

The blocking insulating layer 170L may be conformally formed on surfaces exposed by the dummy gate structure DG and the first recesses RS1. For example, the blocking insulating layer 170L may be formed not only on the surfaces of the dummy gate structure DG but also on exposed surfaces of the first recesses RS1 between the dummy gate structures DG. The blocking insulating layer 170L may include a dielectric material that suppresses epitaxial growth. For example, the blocking insulating layer 170L may include silicon nitride (SiN), silicon oxynitride (SiON), or silicon carbonitride (SiCN). The blocking insulating layer 170L may also be formed on the exposed sidewalls of the fin-type structures FS, for example, on the side surfaces of the sacrificial patterns 120 and the semiconductor patterns 130, to prevent (or reduce) unwanted epitaxial growth in a subsequent process.

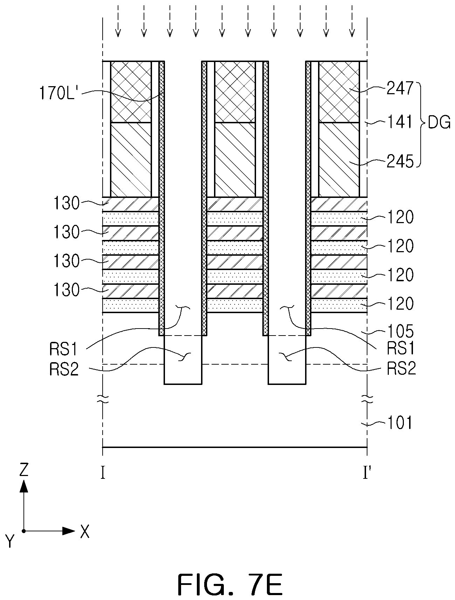

Thereafter, referring to FIG. 7E, portions of the blocking insulating layer 170L located on the bottom surfaces of the first recesses RS1 are removed, and a process of forming the second recess RS2 is performed.

The selective removal process of the blocking insulating layer 170L' to expose the bottom surfaces of the first recesses RS1 may be performed using an anisotropic etching process, such as dry etching. For example, through an anisotropic etching process, not only portions of the blocking insulating layer 170L located on the bottom surfaces of the first recesses RS1, but also portions located on the upper surfaces of the dummy gate structures DG may be removed. As a result, the blocking insulating layer 260 may remain on exposed sidewall portions of the dummy gate structure DG. The blocking insulating layer 170L' may remain to cover the side surfaces of the sacrificial patterns 120 and the semiconductor patterns 130.

The second recesses RS2 are formed by applying an additional etching process to the open bottom surfaces of the first recesses RS1. The second recesses RS2 may be formed to have a greater depth than that of the fin-type active pattern. These second recesses RS2 may provide a space for contact alignment, for example, a space for forming the vertical sacrificial pattern (e.g., 240 in FIG. 7F).

Thereafter, referring to FIG. 7F, the vertical sacrificial patterns 240 may be formed in the second recesses RS2.

Lower surfaces of the vertical sacrificial patterns 240 may be defined by the depth of the second recesses RS2. The lower surfaces of the vertical sacrificial patterns 240 may have a level lower than that of the lower surface of the fin-type active pattern 105, for example, the lower surface of the device isolation layer 110. The vertical sacrificial patterns 240 may include a material having a selectivity with a material of the substrate 101. For example, the substrate 101 may be silicon, and the vertical sacrificial patterns 240 may be silicon germanium (SiGe). The vertical sacrificial patterns 240 may have a relatively high germanium composition ratio, similar to the sacrificial patterns 120.

The vertical sacrificial patterns 240 are grown from the exposed surface of the second recesses RS2. In some example embodiments, the vertical sacrificial patterns 240 may be overgrown and formed to cover a partial region of the remaining blocking insulating layer 170L'.

Referring to FIG. 8A, the vertical sacrificial patterns 240 may be formed to have a level higher than that of a lower surface of at least the lowermost sacrificial pattern 120U. The upper portion 240P of the vertical sacrificial patterns 240 may have a protruding structure defined by a crystal plane. A space around the protruding upper portion 240P of the vertical sacrificial patterns 240 may gradually narrow in a downward direction.

Next, referring to FIG. 7G, the exposed blocking insulating layer 170L' may be removed to form the sidewall insulating film 170.

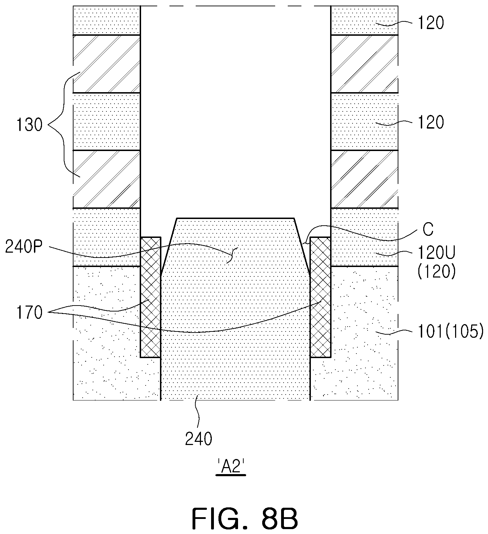

As described above, even if there is a space around the protruding upper portion 240P of the vertical sacrificial patterns 240, the space gradually narrows in the downward direction, so that, in the subsequent removal process of the blocking insulating layer 170L', a portion of the blocking insulating layer located in that space may remain. As a result, as illustrated in FIG. 8B, a portion of the blocking insulating layer may remain to cover at least a portion of the lowermost sacrificial pattern 120U. As such, the sidewall insulating film 170 may be disposed between the vertical sacrificial patterns 240 and the substrate 101 (e.g., the fin-type active pattern 105) and may extend to a partial region of the lowermost sacrificial pattern 120U.

The portion extending from the sidewall insulating film 170 to the lowermost sacrificial pattern 120U may prevent (or reduce) damage to the vertical sacrificial patterns 240, which are formed of a material similar to that of the sacrificial pattern 120, during the process of removing the dummy gate structure DG (e.g., refer to FIG. 9A). In addition, a portion of the sidewall insulating film 170 located on the side surface of the substrate 101 may prevent (or reduce) loss of the source/drain patterns 150A and 150B during a process of removing the substrate 101 (refer to FIG. 9D).

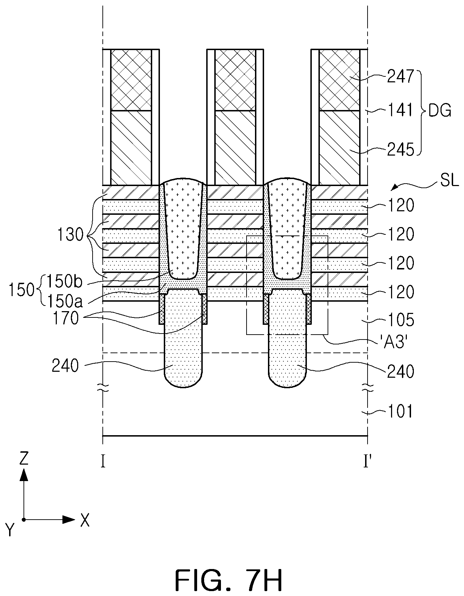

Thereafter, referring to FIG. 7H, an epitaxial growth process may be performed for the first and second source/drain patterns 150A and 150B.

First and second source/drain patterns 150A and 150B are formed by growing an epitaxial on the side surfaces of the sacrificial patterns 120 and the semiconductor pattern 130 exposed by the first recesses RS1 on the vertical sacrificial patterns 240. The first and second source/drain patterns 150A and 150B may include impurities through in-situ doping. Within the first recesses RS1, the first and second source/drain patterns 150A and 150B may be in contact with the sacrificial patterns 120 and the semiconductor patterns 130. The vertical sacrificial patterns 240 may be connected to lower surfaces of the first and second source/drain patterns 150A and 150B, respectively.

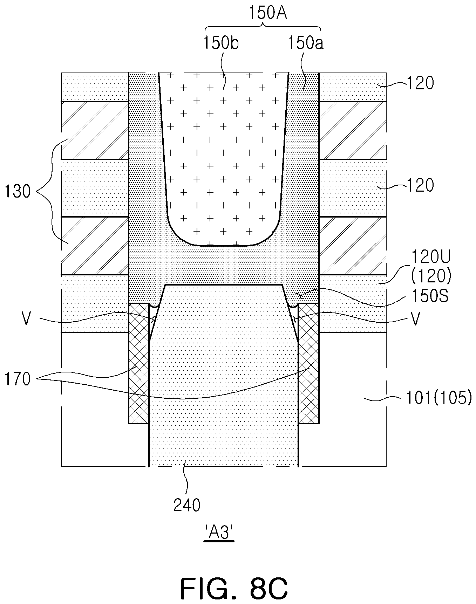

Referring to FIG. 8C, along the space around the upper portion 240P of the vertical sacrificial patterns 240, the lower surfaces of the first and second source/drain patterns may have a protruding portion 150S. In some example embodiments, a portion of a space V of the upper portion 240P of the vertical sacrificial patterns 240 may remain even after epitaxial growth. Some of these vertical sacrificial patterns 240 may be used as elements that provide a space for forming a backside contact structure.

FIGS. 9A to 9H are cross-sectional views of each major process illustrating another partial process (e.g., contact formation process) of the method of manufacturing a semiconductor device according to some example embodiments of the present inventive concepts.

Referring to FIG. 9A, the first interlayer insulating layer 161 may be formed, and the dummy gate structures DS and sacrificial patterns 120 may be removed.

The first interlayer insulating layer 161 may be formed to cover the dummy gate structures DG and the first and second source/drain patterns 150A and 150B, and then a planarization process may be formed thereon. Through the planarization process, the mask pattern 247 may be removed and the sacrificial gate layer 245 and the sacrificial patterns 120 may be selectively removed to form gate spaces DH and gap regions OP. The gate spaces DH and gap regions OP may be provided as spaces for forming the gate structure GS surrounding the semiconductor patterns 130.

In this process, since the vertical sacrificial patterns 240 include a similar material (e.g., SiGe) to that of the sacrificial patterns 120, damage to the vertical sacrificial patterns 240 may be prevented (or reduced) by the previously prepared sidewall insulating film 170 during the process of removing the sacrificial patterns 120, especially, even after the lowermost sacrificial pattern 120U is removed.

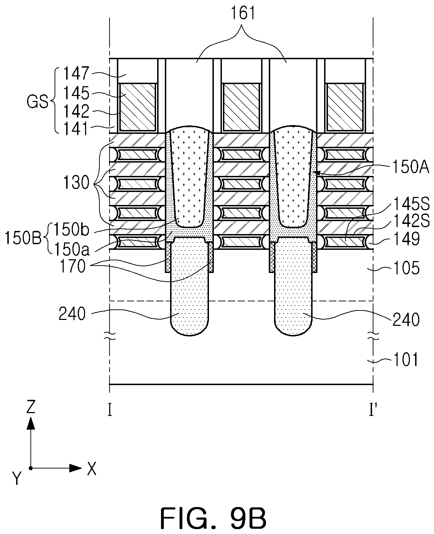

Subsequently, referring to FIG. 9B, the gate spaces DH and gap regions OP form the gate structure GS surrounding the semiconductor patterns 130.

The gate structures GS may be formed by sequentially forming the gate insulating film 142 and the gate electrode 145. In some example embodiments, before forming the gate insulating film 142 and the gate electrode 145, internal spacers 149 may be formed on the epitaxial surfaces exposed to the gap regions OP. After forming the internal spacers 149, the gate insulating film 142 may be conformally formed on the surfaces of the gate spaces DH and gap regions OP. After forming the gate insulating film 142, the remaining spaces may be filled with the gate electrode 145. After etching back the gate electrodes 145 in the gate regions DH, the gate capping layer 147 may be formed in the removed region of the gate electrodes.

Thereafter, referring to FIG. 9C, the second contact structure 180 connected to the second source/drain pattern 150B is formed, and a first interconnection structure connected to the second contact structure 180 is formed.

After forming the second interlayer insulating layer 162, a contact hole connected to the second source/drain pattern 150A is formed through the first and second interlayer insulating layers 161 and 162, and the second contact structure 180 may be formed by filling the contact hole with a conductive material. A lower surface of the contact hole may extend into the second source/drain pattern 150A.

Subsequently, referring to FIG. 9D, the substrate 101 may be selectively removed.

Before the substrate 101 removal process, a process of polishing the substrate 101 to a certain thickness may first be performed. For example, the substrate 101 may be removed and thinned by a lapping, grinding, or polishing process. Subsequently, the remaining substrate region may be removed through a wet etching and/or oxidation process. During the removal of the substrate 101, an etchant may affect the first and second source/drain patterns 150A and 150B on the substrate 101 (e.g., the upper surface of the fin-type active pattern 105). However, in some example embodiments, such an etchant may be blocked by the sidewall insulating film 170 as illustrated in FIG. 10A. In this manner, the sidewall insulating film 170 may prevent (or reduce) loss of the first and second source/drain patterns 150A and 150B even during the removal of the substrate 101.

Next, referring to FIG. 9E, the first insulating material layer 210a is formed in the region in which the substrate 101 was removed.

The first insulating material layer 210a may be formed to cover the vertical sacrificial patterns 240 in the region in which the substrate 101 was removed. The first insulating material layer 210a may have the insulating pattern 210P defined by a space located in the fin-type active pattern 105. The insulating pattern 210P may have a structure extending in the first direction (e.g., the X-direction) (e.g., refer to FIG. 1).

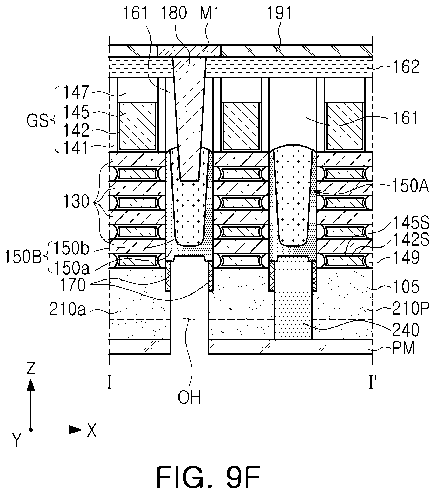

Subsequently, referring to FIG. 9F, after the first insulating material layer 210a is polished to expose the vertical sacrificial patterns 240, some of the vertical sacrificial patterns 240 are selectively removed to form vertical holes OH. In this process, except for the vertical sacrificial patterns 240 on which a backside contact (e.g., the first contact structure 250) is to be formed, other vertical sacrificial patterns 240 are selectively removed. This selective removal may be performed using a photo mask (PM).

Thereafter, referring to FIG. 9G, the second insulating material layer 210b is formed on the first insulating material layer 210a. The second insulating material layer 210b may fill the vertical hole OH to provide the vertical insulating pattern IP connected to the second source/drain patterns 150B. In some example embodiments, the second insulating material layer 210b may include the same material as that of the first insulating material layer 210a. Even though the first and second insulating material layers 210a and 210b include the same material, they are formed through different processes, so an interface therebetween may be visually distinguished. In some example embodiments, the vertical insulating pattern IP may be formed to fill a space (e.g., refer to "v" in FIG. 10A) adjacent to an upper end of the sidewall insulating film 170 (refer to FIG. 4B).

Subsequently, referring to FIG. 9H, the first contact structure 250 connected to the first source/drain pattern 150A may be formed.

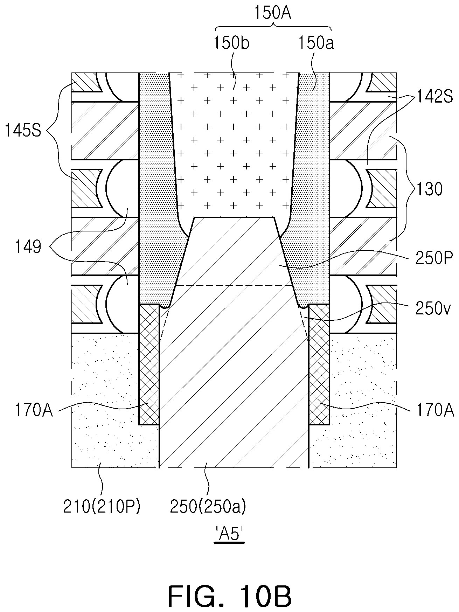

After forming an opening connected to the vertical sacrificial pattern 240 in the second insulating material layer 210b, the vertical sacrificial pattern 240 may be removed, and the first contact structure 250 may be formed in the opening and in a space in which the vertical sacrificial pattern 240 was removed. As illustrated in FIG. 10B, the first contact structure 250 may have an additionally extended upper portion 250P to have a sufficient contact area with the first source/drain pattern 150A. In addition, the first contact structure 250 may have a portion 250v filling a space (e.g., "v" in FIG. 10A) adjacent to the upper end of the sidewall insulating film 170 (refer to FIG. 4A).

The manufacturing process according to the present inventive concepts may be changed into various forms. FIGS. 11A to 11E are cross-sectional views of each major process illustrating another partial process (e.g., a contact formation process) of a method of manufacturing a semiconductor device according to some example embodiments of the present inventive concepts.

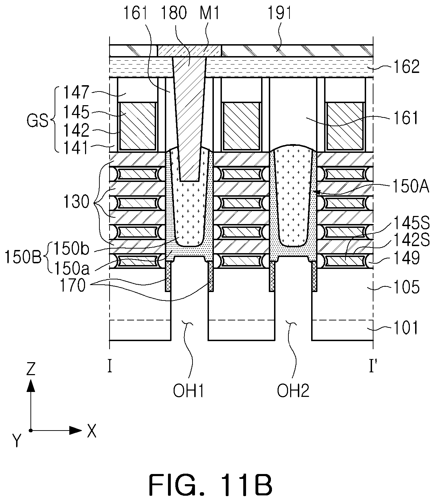

First, referring to FIG. 11A, as a process following the process of FIG. 9C, the substrate 101 may be thinned to expose the lower surface of the vertical sacrificial pattern 240. Next, referring to FIG. 11B, the vertical sacrificial pattern 240 is removed from the exposed lower surface of the vertical sacrificial pattern 240 to form vertical holes OH1 and OH2.

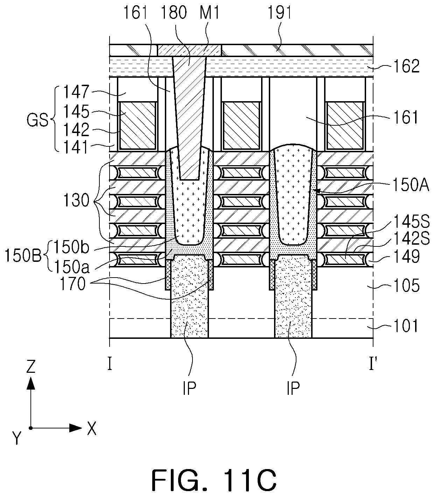

Thereafter, referring to FIG. 11C, the vertical insulating patterns IP may be formed in the vertical holes OH1 and OH2, respectively.

The vertical insulating patterns IP may be formed by forming an insulating material layer to fill the vertical holes OH1 and OH2 and then performing a planarization process to remove an insulating material layer portion from the lower surface of the substrate 101. The vertical insulating patterns IP may contact the lower surfaces of the first and second source/drain patterns 150A and 150B, respectively. The vertical insulating patterns IP may include an insulating material that may be easily removed by a wet etching process. The vertical insulating patterns IP may include a material, such as aluminum oxide (AlO), for example.

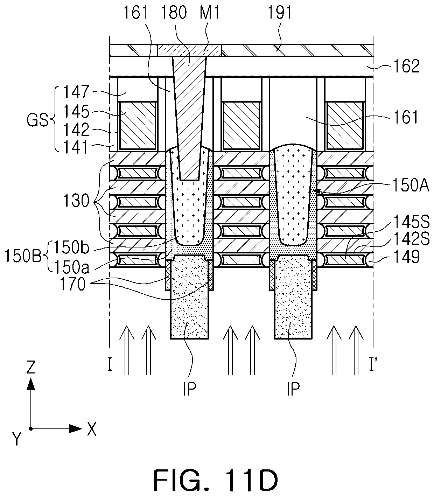

Subsequently, referring to FIG. 11D, the substrate 101 is selectively removed. The substrate 101 may be removed by a wet etching and/or oxidation process. Similarly to previous example embodiments (e.g., refer to FIG. 9D), an etchant used during removal of the substrate 101 may be blocked from reaching the first and second source/drain patterns 150A and 150B by the sidewall insulating film 170.

Thereafter, referring to FIG. 11E, the insulating base layer 210 is formed. The insulating base layer 210 may have the insulating pattern 210P defined by the space located in the fin-type active pattern 105. The insulating pattern 210P may have a structure extending in the first direction (e.g., the X-direction) (e.g., refer to FIG. 1). In some example embodiments, the insulating base layer 210 may include an insulating material different from that of the vertical insulating pattern IP.

Subsequently, an opening connected to the vertical insulating pattern IP below the first source/drain pattern 150A is formed in the insulating base layer 210, and the vertical insulating pattern IP is removed through the opening. Thereafter, the first contact structure 250 may be formed in the space from which the vertical insulating pattern IP was removed and the opening. The vertical insulating pattern IP located in the lower region of the second source/drain pattern 150B may remain buried in the insulating base layer 210.

According to some example embodiments described above, by introducing the sidewall insulating film in the lower region of the multi-channel structure, damage to the contact alignment portion when removing the dummy gate structure and/or loss of the source/drain patterns when removing the substrate may be effectively prevented (or reduced).

While example embodiments have been illustrated and described above, it will be apparent to those skilled in the art that modifications and variations could be made without departing from the scope of the present inventive concepts as defined by the appended claims. Embodiments are set out in the following clauses:
Clause 1. A semiconductor device comprising: an insulating base layer having a protruding insulating pattern, the protruding insulating pattern extending in a first direction; a plurality of semiconductor patterns stacked on the insulating pattern and spaced apart from each other in a direction, perpendicular to an upper surface of the insulating base layer; a gate structure extending in a second direction intersecting the first direction, and surrounding the plurality of semiconductor patterns; first and second source/drain patterns disposed on the insulating pattern and respectively connected to both side surfaces of the plurality of semiconductor patterns in the first direction; an interlayer insulating layer covering the first and second source/drain patterns; a first contact structure connected to the first source/drain pattern through the insulating base layer; and a first sidewall insulating film disposed between an upper portion of the first contact structure and an upper portion of the insulating pattern and extending to cover a side surface of a portion of the gate structure located below a lowermost semiconductor pattern among the plurality of semiconductor patterns.
Clause 2. The semiconductor device of clause 1, wherein an upper end of the first sidewall insulating film is lower than a lower surface of the lowermost semiconductor pattern.
Clause 3. The semiconductor device of clause 1 or 2, wherein an upper surface of the first contact structure is higher than a level of the upper end of the first sidewall insulating film.
Clause 4. The semiconductor device of any one of clauses 1, 2 or 3, wherein a portion of the first contact structure adjacent to the upper end of the first sidewall insulating film is lower than the upper end of the first sidewall insulating film.
Clause 5. The semiconductor device of any one preceding clause, wherein the upper surface of the first contact structure overlaps the lowermost semiconductor pattern in a horizontal direction or is higher than an upper surface of the lowermost semiconductor pattern.
Clause 6. The semiconductor device of any one preceding clause, wherein the upper portion of the insulating pattern covered by the first sidewall insulating film has a width in the range of 0.5 nm to 10 nm.
Clause 7. The semiconductor device of any one preceding clause, wherein the portion of the gate structure covered by the first sidewall insulating film is in the range of 0.5 nm to 5 nm.
Clause 8. The semiconductor device of any one preceding clause, wherein a thickness of the first sidewall insulating film is in the range of 0.5 nm to 3 nm.
Clause 9. The semiconductor device of any one preceding clause, wherein a width of the first contact structure in the second direction corresponds to a width of the insulating pattern in the second direction.
Clause 10. The semiconductor device of any one preceding clause, further comprising: a device isolation layer disposed on the insulating base layer and defining the insulating pattern, wherein, in a cross-section in the second direction, a side surface of the first contact structure is in contact with the device isolation layer and the first sidewall insulating film has a portion between an upper portion of the device isolation layer and the first contact structure
Clause 11. The semiconductor device of any one preceding clause, further comprising: a vertical insulating pattern connected to a lower surface of the second source/drain pattern and
disposed in the insulating base layer; and a second sidewall insulating film disposed on a sidewall of an upper portion of the vertical insulating pattern and located on a level substantially the same as a level of the first sidewall insulating film.
Clause 12. The semiconductor device of clause 11, further comprising: a second contact structure connected to the second source/drain pattern through the interlayer insulating layer.
Clause 13. The semiconductor device of clause 11 or 12, wherein the vertical insulating pattern includes a material the same as a material of the insulating base layer.
Clause 14. The semiconductor device of clause 11, 12, or 13, wherein the vertical insulating pattern includes a material, different from a material of the insulating base layer, and the vertical insulating pattern is embedded in the insulating base layer.
Clause 15. A semiconductor device comprising: an insulating base layer; a plurality of semiconductor patterns stacked on a protruding portion of the insulating base layer and spaced apart from each other in a vertical direction; first and second source/drain patterns respectively connected to both side surfaces of the plurality of semiconductor patterns in a first direction; a gate structure extending in a second direction intersecting the first direction, and surrounding the plurality of semiconductor patterns; an interlayer insulating layer covering the first and second source/drain patterns; a first contact structure connected to the first source/drain pattern through the insulating base layer; a second contact structure connected to the second source/drain pattern through the interlayer insulating layer; a first sidewall insulating film surrounding an upper portion of the first contact structure, and extending from a side surface of the protruding portion of the insulating base layer, the first sidewall insulating film having an upper end on a level lower than a level of a lower surface of a lowermost semiconductor pattern among the plurality of semiconductor patterns; a vertical insulating pattern connected to a lower surface of the second source/drain pattern and disposed in the insulating base layer; and a second sidewall insulating film surrounding an upper portion of the vertical insulating pattern and located on a level substantially the same as a level of the first sidewall insulating film.
Clause 16. The semiconductor device of clause 15, wherein an upper surface of the first contact structure is higher than an upper surface of the vertical insulating pattern.
Clause 17. The semiconductor device of clause 15 or 16, wherein the vertical insulating pattern has an upper surface higher than a level of an upper end of the second sidewall insulating film.
Clause 18. The semiconductor device of clause 15, 16, or 17, wherein an edge region of the upper surface of the vertical insulating pattern has a portion lower than an upper end of the second sidewall insulating film.
Clause 19. The semiconductor device of any one of clauses 15 to 18, wherein the vertical insulating pattern has an upper surface lower than a level of an upper end of the second sidewall insulating film.
Clause 20. A semiconductor device comprising: an insulating base layer; a plurality of semiconductor patterns stacked on the insulating base layer and spaced apart from each other;
a gate structure surrounding the plurality of semiconductor patterns; first and second source/drain patterns disposed on the insulating base layer and connected to both side surfaces of the plurality of semiconductor patterns, respectively; a contact structure connected to first source/drain patterns through the insulating base layer; a sidewall insulating film disposed between an upper portion of the contact structure and an upper portion of the insulating base layer and extending onto a region of a portion of the gate structure located below a lowermost semiconductor pattern among the plurality of semiconductor patterns; and a power transmission line disposed on a lower surface of the insulating base layer and connected to the contact structure.

## Claims

1. A semiconductor device, comprising:
an insulating base layer having an insulating pattern, the insulating pattern extending in a first direction;
a plurality of semiconductor patterns stacked on the insulating pattern and spaced apart from each other in a direction perpendicular to an upper surface of the insulating base layer;
a gate structure extending in a second direction intersecting the first direction, the gate structure surrounding the plurality of semiconductor patterns;
first and second source/drain patterns on the insulating pattern and respectively connected to both side surfaces of the plurality of semiconductor patterns in the first direction;
an interlayer insulating layer covering the first and second source/drain patterns;
a first contact structure connected to the first source/drain pattern through the insulating base layer; and
a first sidewall insulating film between an upper portion of the first contact structure and an upper portion of the insulating pattern, the first sidewall insulating film extending to cover a side surface of a portion of the gate structure located below a lowermost semiconductor pattern among the plurality of semiconductor patterns.

2. The semiconductor device of claim 1, wherein an upper end of the first sidewall insulating film is lower than a lower surface of the lowermost semiconductor pattern.

3. The semiconductor device of claim 1 or 2, wherein an upper surface of the first contact structure is at a level higher than a level of the upper end of the first sidewall insulating film.

4. The semiconductor device of claim 1, 2, or 3, wherein a portion of the first contact structure adjacent to the upper end of the first sidewall insulating film is lower than the upper end of the first sidewall insulating film.

5. The semiconductor device of any one of claims 1 to 4, wherein the upper surface of the first contact structure overlaps the lowermost semiconductor pattern in a horizontal direction or is higher than an upper surface of the lowermost semiconductor pattern.

6. The semiconductor device of any one of claims 1 to 5, wherein
the upper portion of the insulating pattern covered by the first sidewall insulating film has a width in a range of 0.5 nm to 10 nm.

7. The semiconductor device of any one of claims 1 to 6, wherein the portion of the gate structure covered by the first sidewall insulating film has a width in a range of 0.5 nm to 5 nm.

8. The semiconductor device of any one of claims 1 to 7, wherein a thickness of the first sidewall insulating film is in a range of 0.5 nm to 3 nm.

9. The semiconductor device of any one of claims 1 to 8, wherein a width of the first contact structure in the second direction corresponds to a width of the insulating pattern in the second direction.

10. The semiconductor device of any one of claims 1 to 9, further comprising:
a device isolation layer on the insulating base layer and defining the insulating pattern,
wherein, in a cross-section in the second direction, a side surface of the first contact structure is in contact with the device isolation layer and the first sidewall insulating film has a portion between an upper portion of the device isolation layer and the first contact structure.

11. The semiconductor device of any one of claims 1 to 10, further comprising:
a vertical insulating pattern connected to a lower surface of the second source/drain pattern, the vertical insulating pattern arranged in the insulating base layer; and
a second sidewall insulating film on a sidewall of an upper portion of the vertical insulating pattern.

12. The semiconductor device of claim 11, wherein the second sidewall insulating film arranged on a level same as a level of the first sidewall insulating film.

13. The semiconductor device of claim 11 or 12, further comprising:
a second contact structure connected to the second source/drain pattern through the interlayer insulating layer.

14. The semiconductor device of claim 11, 12 or 13wherein the vertical insulating pattern includes a material same as a material of the insulating base layer.

15. The semiconductor device of any one of claims 11 to 14, wherein the vertical insulating pattern includes a material, different from a material of the insulating base layer, and the vertical insulating pattern is embedded in the insulating base layer.
